# EUROPEAN PATENT SPECIFICATION

(11) **EP 4 400 866 B1**
(45) Date of publication and mention of the grant of the patent: **28.10.2026**
(21) Application number: 22864752.5
(22) Date of filing: 05.09.2022
(51) Int. Cl.: G01S 7/4863, G01C 3/06, G01S 7/484, G01S 17/894, G01S 17/10, G01S 7/497, G01S 7/481, H10F 39/18, G01S 7/4865

(54) **DISTANCE IMAGE CAPTURING DEVICE AND DISTANCE IMAGE CAPTURING METHOD**
ENTFERNUNGSBILDAUFNAHMEVORRICHTUNG UND ENTFERNUNGSBILDAUFNAHMEVERFAHREN
DISPOSITIF DE CAPTURE D'IMAGE DE DISTANCE ET PROCÉDÉ DE CAPTURE D'IMAGE DE DISTANCE

(30) Priority: 06.09.2021 JP 2021144666
(43) Date of publication of application: 17.07.2024
(73) Proprietor: Toppan Holdings Inc., Tokyo 110-0016 (JP)
(72) Inventor: HATAKEYAMA Kunihiro, Tokyo 110-0016 (JP); HARIU Hiromitsu, Tokyo 110-0016 (JP)
(74) Representative: Plasseraud IP
(86) International application number: PCT/JP2022/033259
(87) International publication number: WO 2023/033170

(56) References cited:
- EP-A1- 3 767 335
- WO-A1-2014/208018
- WO-A1-2016/027656
- WO-A1-2020/218283
- JP-A- 2010 025 906
- JP-A- 2010 267 720
- JP-A- 2014 159 994
- US-A1- 2013 162 973
- US-A1- 2015 301 177
- US-A1- 2017 234 983
- US-A1- 2019 391 238

## Description

### [Technical Field]

The present invention relates to range imaging devices and range imaging methods.

The present application claims the benefit of priority from Japanese Patent Application JP2021144666 filed in Japan on September 6, 2021.

### [Background Art]

Time of flight (hereinafter referred to as TOF) type range imaging devices are known which measure the distance to an object based on the time of flight of light, using the known speed of light (e.g., see PTL 1).

Such a TOF type range imaging device includes a light source unit emitting light, and an imaging unit including a pixel array in which a plurality of pixel circuits that detect light for measuring a distance are arranged in a two-dimensional matrix (in an array). The pixel circuits each include a photoelectric conversion element (e.g., photodiode) as a component which generates electrical charge corresponding to the intensity of light.

With this configuration, the TOF type range imaging device can acquire information on the distance between itself and the object or can capture an image of the object in a measurement space (three-dimensional space).

Document US2017/234983 discloses a ranging method which uses a light source and a range sensor with charge-generating and charge-accumulating areas, wherein charges are gathered in two time periods and stored in separate areas to determine the distance to an object.

Document US2013/162973 discloses a distance measuring system which uses pulsed light and stores photoelectrons based on received light energy during specific time periods, wherein first and second light-receiving periods capture different parts of the reflected light's intensity curve and distance is calculated using the ratio of photoelectrons stored in these two periods via a time-of-flight method.

Document US2015/301177 discloses a distance measuring method and system wherein a TOF distance measurement system improves accuracy cost-effectively by varying light emission intensity, a sensor accumulating signals over multiple periods, with the signal amount changing nonlinearly with object distance.

Document US2019/391238 discloses a method wherein depth imagers use time-of-flight to measure object distances by detecting reflected light with sensor arrays.

Document WO2020/218283 discloses a pulsed light source which emits radiation with time-varying intensity and an image sensor which captures reflected light in two exposures.

### [Citation List]

### [Patent Literature]

PTL 1: JP 2015-29054 A

### [Summary of the Invention]

### [Technical Problem]

In the range imaging device described above, emitted light pulses are reflected by an object, the reflected light is received by the pixels, the received reflected light is photoelectrically converted using the photoelectric conversion element, and charge obtained by the photoelectric conversion is distributed to charge integration units at predetermined time intervals.

Thus, in the range imaging device, charge is integrated in the individual charge integration units, and the distance to the object is calculated based on the ratio of charge integrated in two charge integration units (charge ratio).

However, light pulses do not have an ideal square waveform, but have a waveform in which the rise and fall are less sharp (not right-angled).

Therefore, when the time period for distributing charge to the charge integration units from the photoelectric conversion element (width of integration drive signals TX, i.e., gate pulse width, described later) is equal to the width of light pulses (i.e., light pulse width), the light pulse width may become smaller (shorter) than the time period of distributing charge, due to the light pulse waveform becoming less sharp, and charge may be distributed to only one of two charge integration units.

In particular, bias in the distributed charge becomes particularly pronounced at the timing when the combination of two charge integration units to which reflected light is distributed is switched to another combination in the plurality of charge integration units.

Thus, if the light pulse width becomes smaller (shorter) than the charge distribution time period due to the light pulse waveform becoming less sharp, charge tends to be distributed to only either one of the charge integration units.

Consequently, at the timing when the combination of the charge integration units is switched to another combination, change in charge ratio may become less sharp relative to actual distance change, and accordingly, the distance may vary in response to the error in charge ratio due to noise, etc., and the temporal resolution and spatial resolution of the measured distance may be deteriorated.

The present invention has been made in light of the circumstances set forth above and aims to provide a range imaging device and a range imaging method, which are able to prevent charge from being integrated in only one of two charge integration units, and to reduce the error between the distance obtained based on a charge ratio of the charge integration units and the actual distance between the pixel and the object.

### [Solution to Problem]

In order to solve the issues set forth above, a range imaging device is defined in the appended claims.

### [Advantageous Effects of the Invention]

As described above, there can be provided a range imaging device and a range imaging method, which are able to prevent charge from being integrated in only one of two charge integration units due to the light pulse width becoming smaller due to the light pulse waveform becoming less sharp, and are able to reduce the error between the distance obtained based on a charge ratio of the charge integration units and the actual distance between the pixel and the object.

### [Brief Description of the Drawings]

Fig. 1 is a schematic block diagram illustrating a configuration of a range imaging device according to a first embodiment of the present invention.
Fig. 2A is a diagram illustrating an example of a pulse shape of light pulses emitted from a light source unit.
Fig. 2B is a diagram illustrating an example of a pulse shape of light pulses emitted from a light source unit.
Fig. 3 is a circuit diagram illustrating a configuration example of a pixel circuit disposed in a range image sensor of the range imaging device according to the first embodiment of the present invention.
Fig. 4 is a timing chart illustrating transfer of charge generated in a photoelectric conversion element to individual charge integration units.
Fig. 5 is a diagram illustrating correspondence between charge ratio of charge integration units and distance between the range imaging device and an object.
Fig. 6 is a diagram illustrating charge ratio gradients for the case of a light pulse width equal to the width of an integration drive signal, and the case of a light pulse width larger than the width of the integration drive signal.
Fig. 7A is a graph illustrating correspondence between charge ratio and delay time according to the present embodiment.
Fig. 7B is a graph illustrating correspondence between charge ratio and delay time according to the present embodiment.
Fig. 8A is a diagram illustrating temporal resolution of distance to an object measured by a range imaging device.
Fig. 8B is a diagram illustrating spatial resolution of distance to an object measured by a range imaging device.
Fig. 9 is a flow chart illustrating processing of selecting a width of light pulses used for distance measurement in a light pulse width setting mode according to the present embodiment.
Fig. 10A is a diagram illustrating a correspondence table indicating a relationship between charge ratio and estimated distance according to a second embodiment.
Fig. 10B is a diagram illustrating a configuration example of the correspondence table indicating a relationship between charge R and estimated distance according to the second embodiment.

### [Description of the Embodiments]

### <First Embodiment>

With reference to the drawings, a first embodiment of the present invention will be described.

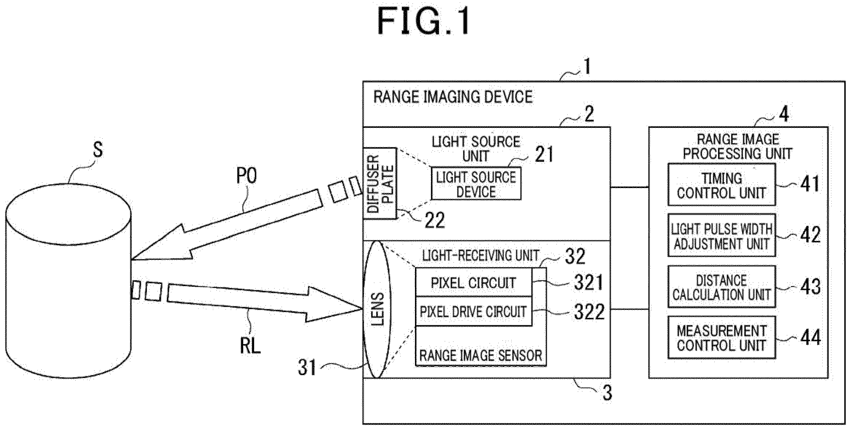

Fig. 1 is a schematic block diagram illustrating a configuration of a range imaging device according to a first embodiment of the present invention. A range imaging device 1 configured as shown in Fig. 1 includes a light source unit 2, a light-receiving unit 3, and a range image processing unit 4. Fig. 1 also shows an object S whose distance is to be measured by the range imaging device 1. A range imaging element may be, for example, a range image sensor 32 (described later) in the light-receiving unit 3.

The light source unit 2 emits light pulses PO into a space as an imaging target where the object S is present whose distance is to be measured by the range imaging device 1 under the control of the range image processing unit 4. The light source unit 2 may be, for example, a surface-emitting semiconductor laser module such as a vertical-cavity surface-emitting laser (VCSEL). The light source unit 2 includes a light source device 21 and a diffuser plate 22.

The light source device 21 is a light source that emits laser light in the near infrared wavelength band (e.g., wavelength band of 850 nm to 940 nm) which serves as the light pulses PO to be emitted to the object S. The light source device 21 may be, for example, a semiconductor laser light emitting device. The light source device 21 emits pulsed laser light under the control of a timing control unit 41.

The diffuser plate 22 is an optical component that diffuses laser light in the near infrared wavelength band emitted from the light source device 21 over the emission surface area of the object S. Pulsed laser light diffused by the diffuser plate 22 is emitted as the light pulses PO and applied to the object S.

The light-receiving unit 3 receives reflected light RL arising from reflection of the light pulses PO from the object S, which is the object whose distance is to be measured by the range imaging device 1, and outputs a pixel signal according to the received reflected light RL. The light-receiving unit 3 includes a lens 31 and a range image sensor 32.

The lens 31 is an optical lens that guides the incident reflected light RL to the range image sensor 32. The lens 31 outputs the incident reflected light RL toward the range image sensor 32, so that the light can be received by (be incident on) pixel circuits provided to the light-receiving region of the range image sensor 32.

The range image sensor 32 is an imaging device used for the range imaging device 1. The range image sensor 32 includes a plurality of pixel circuits 321 disposed in a two-dimensional light-receiving region, and a pixel drive circuit 322 that controls the pixel circuits 321.

The pixel circuits 321 each include one photoelectric conversion element (e.g., photoelectric conversion element PD described later), a plurality of charge integration units (e.g., charge integration units CS1 to CS4 described later) corresponding to this photoelectric conversion element, and components for distributing charge to the individual charge integration units.

Under the control of the timing control unit 41, the range image sensor 32 distributes charge, which has been generated by the photoelectric conversion element, to the charge integration units. Also, the range image sensor 32 outputs pixel signals according to the charge distributed to the charge integration units. The range image sensor 32, in which a plurality of pixel circuits are arranged in a two-dimensional matrix, outputs single-frame pixel signals corresponding to the respective pixel circuits.

The range image processing unit 4 controls the range imaging device 1 and calculates the distance to the object S.

The range image processing unit 4 includes the timing control unit 41, a light pulse width adjustment unit 42, a distance calculation unit 43, and a measurement control unit 44.

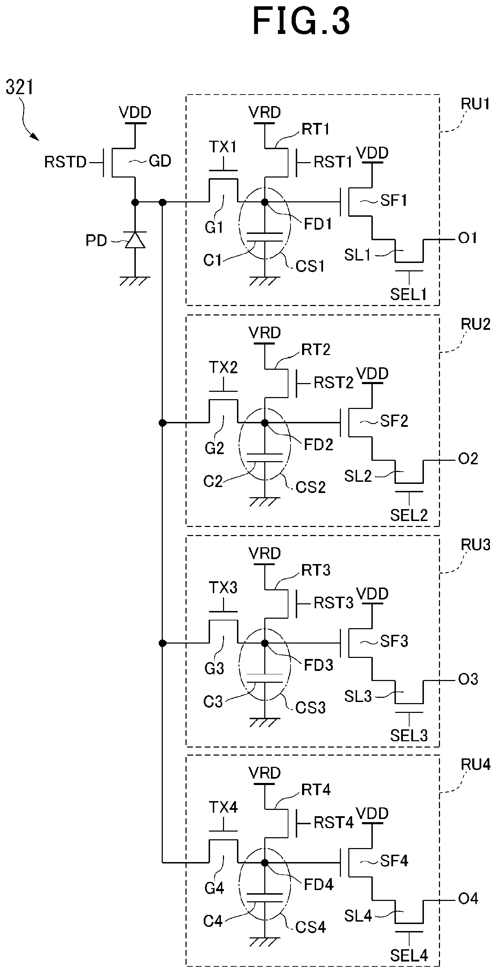

The timing control unit 41 controls timing of outputting various control signals required for measuring a distance, under the control of the measurement control unit 44. The various control signals refer to, for example, signals for controlling emission of the light pulses PO, signals for distributing the reflected light RL to the plurality of charge integration units (integration drive signals TX for driving transfer transistors G described later), signals for controlling the number of distributions per frame, and other signals. The number of distributions refers to the number of times of repeating the processing for distributing charge generated due to incident light, from the photoelectric conversion element PD to the charge integration units CS (see Fig. 3) via the transfer transistors G.

The integration drive signals TX for driving the transfer transistors G are gate pulses, and a width TP1 of the integration drive signals TX for driving the transfer transistors G is a gate pulse width TP1. The light pulses PO have a width TPP, that is, a light pulse width TPP.

The light pulse width adjustment unit 42 adjusts the width TPP of the light pulses PO emitted from the light source device 21 of the light source unit 2.

Specifically, according to the timing control unit 41, the light source device 21 causes the light source unit 2 to emit the light pulses PO in synchrony with the integration drive signals TX (described later) that drive the transfer transistors G distributing charge to the charge integration units CS.

In this case, the light pulse width adjustment unit 42 causes the light source device 21 to emit the light pulses PO with a width TPP that is not equal to the width TP1 (time period for distributing charge to the charge integration units CS with the transfer transistors G turned on, i.e., on-period of the transfer transistors G for them to distribute charge) of the integration drive signals TX, but with a light pulse width TPP (> TP1) that has been adjusted according to the degree of distortion of the light pulses PO.

The width TP1 (gate pulse width TP1) of the integration drive signals TX mentioned herein is assumed to be a pulse width set by a resistor.

Control signals defined by the rise timing and the rise period of light pulses, or defined by the period from the rise timing to the fall timing of light pulses may be used.

With the output peak of light pulses as 100%, the width TPP of light pulses may be defined as a period of intensity greater than 10%, or a period of intensity greater than 90%.

Specifically, in the present embodiment, the width TPP of the light pulses PO is set to be larger than the rise period (period of H level) of a specific transfer transistor G (that rises first and reaches H level) and the rise period of the subsequently rising transfer transistor G, among the transfer transistors G.

The rise period of a specific transfer transistor G and the rise period of the subsequently rising transfer transistor G correspond to the width TP1 (gate pulse width TP1) of the integration drive signals TX.

Under the control of the measurement control unit 44, the distance calculation unit 43 outputs distance information (quantized as a gradation) that is a distance from the range imaging device 1 (each pixel) to the object S calculated based on a pixel signal (voltage corresponding to the integrated charge Q described later) outputted from the range image sensor 32.

The distance calculation unit 43 calculates a delay time Td from when the light pulses PO are emitted until when the reflected light RL is received, based on the charge integrated in the plurality of charge integration units CS. The distance calculation unit 43 calculates the distance from the range imaging device 1 to the object S according to the calculated delay time Td.

The measurement control unit 44 selects the mode for each frame repeated at a frame cycle, from a light pulse width setting mode in which the width TPP of the light pulses PO is arbitrarily changed and determined to adjust the light pulse width TPP, and a distance measurement charge acquisition mode that is a normal frame in which a distance is measured using the light pulses PO with a set width TPP.

The measurement control unit 44 controls timing for the timing control unit 41 and controls calculation for the distance calculation unit 43, according to each mode that is the light pulse width setting mode or the distance measurement charge acquisition mode (described later in detail).

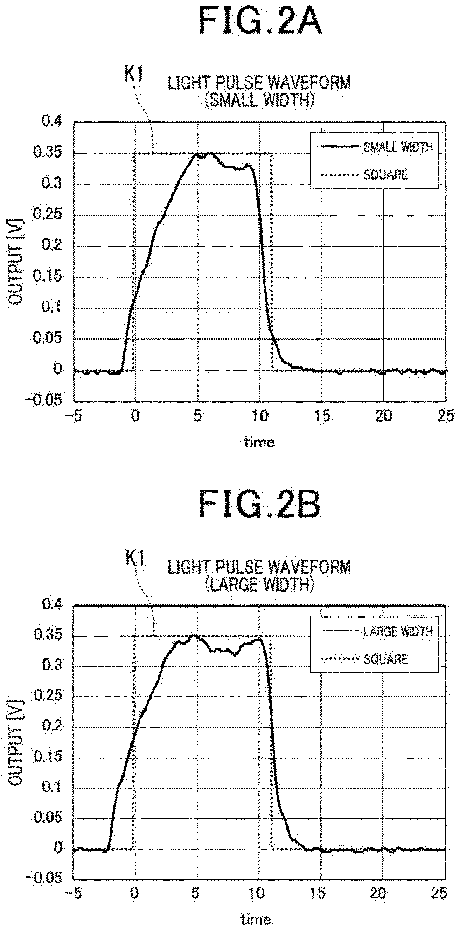

Figs. 2A and 2B are diagrams each illustrating an example of a pulse shape of the light pulses PO emitted from the light source device 21. Fig. 2A shows, for example, a waveform of the light pulses PO with a width TPP (=TP1) equal to the width TP1 of the integration drive signals TX for driving the transfer transistors G. In Fig. 2A, the horizontal axis indicates time and the vertical axis indicates intensity (voltage measured using a photodetector).

The light pulses PO may be ideally emitted with a waveform equal to the square waveform of the integration drive signals TX indicated by the dot line K1.

However, actually, the width TPP of the light pulses PO may become smaller than the width TP1 of the integration drive signals TX, which has been set to be the width TPP of the light pulses PO, due to the rising and falling shapes in the waveform of the light pulses PO becoming less sharp (due to the waveform becoming less sharp due to the irradiation time constant).

Thus, as mentioned in the Technical Problem, while charge is distributed to the charge integration units CS from the photoelectric conversion element PD, the width TPP of the light pulses PO becomes smaller than the width TP1 of the integration drive signals TX due to the waveform becoming less sharp.

Thus, when calculating a distance based on the ratio between the integrated charges Q of two charge integration units CS, the state in which charge is distributed to only one of the two charge integration units CS may continue for a predetermined period of time, or charge distributed to one of the two charge integration units CS may become minute, and resultantly, the distance calculation may tend to be adversely affected by noise.

Therefore, the distance calculated based on the ratio of charges (charge ratio R described later) integrated in two charge integration units CS may be different from the actual distance.

Fig. 2B shows a waveform of the light pulses PO with a width TPP set to be larger than the width TP1 of the integration drive signals TX. In Fig. 2B, the horizontal axis indicates time and the vertical axis indicates intensity (e.g., voltage with which the waveform of the light pulses was measured using a photodetector, etc.).

Thus, if the waveform of the light pulses PO becomes less sharp, the width TPP of the light pulses PO can be made similar to the width TP1 of the integration drive signals TX indicated by the dot line K1.

Therefore, when calculating a distance based on the ratio of the integrated charges Q integrated in two charge integration units CS, the state in which charge is distributed to only one of the two charge integration units CS may be prevented from continuing for a predetermined period of time, or charge distributed to one of the two charge integration units CS may be prevented from becoming minute (i.e., charge generated in the photoelectric conversion element PD due to reflected light may be prevented from being integrated in a biased manner in one of the charge integration units CS).

Therefore, the distance calculated based on the ratio of the charges integrated in two charge integration units CS can be calculated as a value approximate to the actual distance between the range image sensor 32 and the object S.

With this configuration, in the range imaging device 1, the light source unit 2 emits the light pulses PO in the near infrared wavelength band toward the object S, the light-receiving unit 3 receives the reflected light RL arising from reflection of the light pulses PO from the object S (receives the reflected light RL as incident light in which the reflected light RL is mixed with ambient light), and the range image processing unit 4 outputs distance information indicating the distance measured between the object S and the range imaging device 1.

Although Fig. 1 shows a range imaging device 1 configured to include the range image processing unit 4 inside thereof, the range image processing unit 4 may be a component provided external to the range imaging device 1.

Next, the configuration of a pixel circuit 321 in the range image sensor 32 will be described. Fig. 3 is a circuit diagram illustrating a configuration example of a pixel circuit 321 disposed in the range image sensor 32 of the range imaging device according to the first embodiment of the present invention. The pixel circuit 321 shown in Fig. 3 is a configuration example including four pixel signal readouts RU1 to RU4.

The pixel circuit 321 includes one photoelectric conversion element PD, a charge discharge transistor GD (GD1 or GD2 described later), and four pixel signal readouts RU (RU1 to RU4) which output voltage signals from respective output terminals O. Each of the pixel signal readouts RU includes a transfer transistor G, a floating diffusion FD, a charge storage capacitor C, a reset transistor RT, a source follower transistor SF, and a selection transistor SL. The floating diffusion FD and the charge storage capacitor C configure a charge integration unit CS.

In the pixel circuit 321 shown in Fig. 3, the pixel signal readout RU1 that outputs a voltage signal from an output terminal O1 includes a transfer transistor G1 (transfer MOS transistor), a floating diffusion FD1, a charge storage capacitor C1, a reset transistor RT1, a source follower transistor SF1, and a selection transistor SL1. In the pixel signal readout RU1, the floating diffusion FD1 and the charge storage capacitor C1 configure a charge integration unit CS1. The pixel signal readouts RU2, RU3 and RU4 are configured similarly.

The photoelectric conversion element PD is an embedded photodiode which performs photoelectric conversion of incident light, generates charge corresponding to the incident light, and integrates the generated charge. In the present embodiment, incident light is incident from a space targeted for measurement. In the pixel circuit 321, charge generated by photoelectric conversion of incident light by the photoelectric conversion element PD is distributed to the four charge integration units CS (CS 1 to CS4), and voltage signals corresponding to the distributed charges are outputted to the range image processing unit 4.

The configuration of each pixel circuit disposed in the range image sensor 32 is not limited to the configuration, as shown in Fig. 3, provided with the four pixel signal readouts RU (RU1 to RU4), but the pixel circuit may be configured to include one or more pixel signal readouts RU.

In response to each pixel circuit 321 of the range imaging device 1 being driven, the light pulses PO are emitted during an emission period To and the reflected light RL is received by the range image sensor 32 after a delay time Td. Under the control of the timing control unit 41, the pixel drive circuit 322 supplies integration drive signals TX1 to TX4 to the transfer transistors G1, G2, G3 and G4 according to their respective timings synchronized with emission of the light pulses PO to distribute charge generated in the photoelectric conversion element PD for sequential integration in the charge integration units CS1, CS2, CS3 and CS4.

The pixel drive circuit 322 controls the reset transistors RT and the selection transistors SL using respective drive signals RST and SEL, converts the charge integrated in the charge integration units CS into electrical signals using the source follower transistors SF, and outputs the converted electrical signals to the distance calculation unit 43 via the terminals O.

Under the control of the timing control unit 41, the pixel drive circuit 322 passes and discharges the charge generated in the photoelectric conversion element PD to power sources VDD using a drive signal RSTD (eliminates the charge).

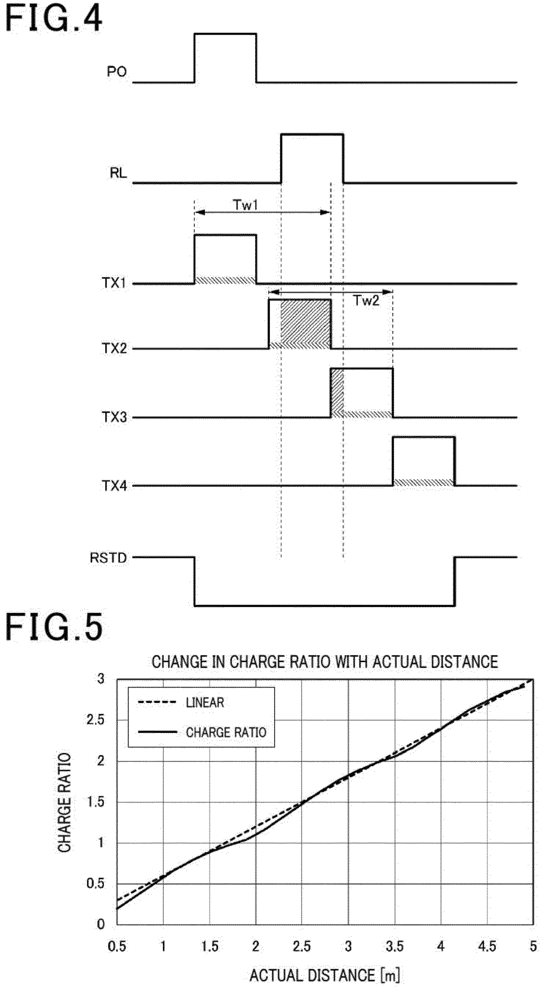

Fig. 4 is a timing chart illustrating transfer of charge generated in the photoelectric conversion element PD to the individual charge integration units CS.

In the timing chart of Fig. 4, the vertical axis indicates pulse level and the horizontal axis indicates time. The timing chart shows correlation between the light pulses PO and the reflected light RL on the time axis, timing of integration drive signals TX1 to TX4 supplied to the respective transfer transistors G1 to G4, and timing of the drive signal RSTD supplied to the charge discharge transistor GD.

The timing control unit 41 causes the light source unit 2 to emit the light pulses PO into the measurement space. Thus, the light pulses PO are reflected by the object S and received by the light-receiving unit 3 as the reflected light RL. Also, the photoelectric conversion element PD generates charge corresponding to ambient light and the reflected light RL. The pixel drive circuit 322, which transfers charge generated in the photoelectric conversion element PD to the charge integration units CS1 to CS4, performs switching control for the transfer transistors G1 to G4.

In other words, the pixel drive circuit 322 supplies the integration drive signals TX1 to TX4 to the transfer transistors G1 to G4 as H-level signals with a predetermined duration (the same duration as the emission period To).

For example, the pixel drive circuit 322 turns on the transfer transistor G1 provided on the transfer path through which charge is transferred to the charge integration unit CS1 from the photoelectric conversion element PD. Thus, the charge photoelectrically converted by the photoelectric conversion element PD is integrated in the charge integration unit CS1 via the transfer transistor G1. After that, the pixel drive circuit 322 turns off the transfer transistor G1. Thus, charge transfer to the charge integration unit CS1 is stopped. In this way, the pixel drive circuit 322 causes the charge integration unit CS1 to integrate charge. The same applies to other charge integration units CS2, CS3 and CS4.

In this case, in a charge integration period in which charge is distributed to the charge integration units CS (period in which charge is integrated in the charge integration units CS in a frame), the integration cycle (corresponding to the width TP1 of the integration drive signals TX driving the transfer transistors G) is repeated so that the integration drive signals TX1, TX2, TX3 and TX4 are supplied to the respective transfer transistors G1, G2, G3 and G4.

Thus, charge corresponding to the incident light is transferred to the charge integration units CS1, CS2, CS3 and CS4 from the photoelectric conversion element PD via the respective transfer transistors G1, G2, G3 and G4. The integration cycle is repeated multiple times in the charge integration period.

Thus, charge is integrated in the charge integration units CS1, CS2, CS3 and CS4 every integration cycle of each of the charge integration units CS1, CS2, CS3 and CS4 during the charge integration period.

Fig. 4 shows a time window Tw1 indicating a state in which charge of the reflected light RL is integrated in the combination of the charge integration units CS1 and CS2, and a time window Tw2 indicating a state in which charge of the reflected light RL is integrated in the combination of the charge integration units CS2 and CS3.

When repeating the integration cycle for each of the charge integration units CS1, CS2, CS3 and CS4, after completing charge transfer (distribution) to the charge integration unit CS4, the pixel drive circuit 322 turns on the charge discharge transistor GD provided on the discharge path through which charge is discharged from the photoelectric conversion element PD, by supplying an H-level drive signal RSTD.

Thus, before restarting the integration cycle for the charge integration unit CS1, the charge discharge transistor GD discards the charge generated in the photoelectric conversion element PD after completing the previous integration cycle for the charge integration unit CS4 (i.e., the photoelectric conversion element PD is reset). In other words, the charge discharge transistor GD, or one or multiple (two or more) discharge transistor(s) GD, discharges the charge from the photoelectric conversion element PD, discharging it in a period other than the period when the charge generated in the photoelectric conversion element PD due to incident light is distributed to and integrated in the individual chare integration units CS1, CS2, CS3 and CS4.

The pixel drive circuit 322 sequentially performs signal processing such as A/D conversion processing for the voltage signals from all the pixel circuits 321 disposed in the light-receiving unit 3 for each row (horizontal array) of the pixel circuits 321.

After that, the pixel drive circuit 322 sequentially outputs the voltage signals subjected to signal processing to the distance calculation unit 43, in the order of columns of the pixel circuits disposed in the light-receiving unit 3.

As described above, the pixel drive circuit 322 repeatedly integrates charge in the charge integration units CS and discards charge photoelectrically converted by the photoelectric conversion element PD in a single frame. Thus, charge corresponding to the intensity of light received by the range imaging device 1 in a predetermined time interval is integrated in the individual charge integration units CS. The pixel drive circuit 322 outputs electrical signals corresponding to single-frame charges integrated in the charge integration units CS to the distance calculation unit 43.

As can be seen from the relationship between the timing of emitting the light pulses PO and the timing of the time window Tw1 in which charge is integrated in the combination of the charge integration units CS1 and CS2, the charge corresponding to external light components, such as ambient light, before emission of the light pulses PO (corresponding to the regions indicated by the diagonal lines from upper left to lower right at TX1 and TX2 of Fig. 4) and the charge corresponding to part of the reflected light RL (corresponding to the region indicated by the diagonal lines from upper right to lower left at TX2 of Fig. 4) are distributed to the combination of the charge integration units CS1 and CS2 and held therein. As can be seen from the relationship between the timing of emitting the light pulses PO and the timing of the time window Tw2 in which charge is integrated in the combination of the charge integration units CS2 and CS3, the charge corresponding to external light components (corresponding to the regions indicated by the diagonal lines from upper left to lower right at TX2 and TX3 of Fig. 4) and the charge corresponding to the reflected light RL (corresponding to the regions indicated by the diagonal lines from upper right to lower left at TX2 and TX3 of Fig. 4) are distributed to the combination of the charge integration units CS2 and CS3 and held therein. Allocation of charge distributed to the charge integration units CS 1 and CS2 or the charge integration units CS2 and CS3 (distribution ratio) is a ratio depending on the delay time Td from when the light pulses PO are reflected by the object S until when the reflected light is incident on the range imaging device 1.

As described above, in the present embodiment, the distance between the range imaging device 1 and the object S is calculated based on the ratio of charge integrated in a combination of two charge integration units CS, e.g., the charge integration units CS1 and CS2, or the charge integration units CS2 and CS3, among the charge integration units CS1, CS2 and CS3.

With the ratio of charge integrated in the combination of the two charge integration units CS linearly changing with the distance (changing at a predetermined rate of change), distance measurement can be performed with high accuracy.

However, with the light pulses PO becoming less sharp and more distorted, the relationship between charge ratio, that is the ratio of charge, and distance is no longer maintained to be linear.

Fig. 5 is a diagram illustrating correspondence between charge ratio of the charge integration units CS, and distance between the range imaging device 1 and the object S.

In Fig. 5, the dashed line indicates a linear relationship and the solid line indicates a relationship in which the width TPP of the light pulses PO is equal to the width TP1 of the integration drive signals TX.

In the relationship between charge ratio and distance, the solid line is deviated from the linear dashed line in the vicinities of 2 m and 4 m. The charge ratio R used herein is determined as follows based on the integrated charges Q1, Q2, Q3 and Q4 integrated in the charge integration units CS1, CS2, CS3 and CS4 and supplied from the range image sensor 32. The following calculation is performed by the light pulse width adjustment unit 42.$R 1 = 1 - {Q}_{1 - 3} / {Q}_{A}$ (1) $R 2 = 2 - {Q}_{2 - 4} / {Q}_{A}$ (2)

In the above Formulas (1) and (2), the following relations are established: ${Q}_{1 - 3} = \left|Q1-Q3\right|$ (3) ${Q}_{2 - 4} = \left|Q2-Q4\right|$ (4) ${Q}_{A} = \left|Q1-Q3\right| + \left|Q2-Q4\right|$ (5)

The charge ratio R1 indicates a charge ratio in the state in which charge of the reflected light RL is integrated in the combination of the charge integration units CS1 and CS2 (the time window Tw1 of Fig. 4).

The charge ratio R2 indicates a charge ratio in the state in which charge of the reflected light RL is integrated in the combination of the charge integration units CS2 and CS3 (the time window Tw2 of Fig. 4).

The vicinity of 2 m in Fig. 5 corresponds to the region in which the time windows switch from Tw1 to Tw2.

During switching of these time windows, an error from the actual distance may occur, as described above, due to the width TPP of the actually emitted light pulses PO becoming smaller than the width TP1 of the integrated drive signals TX.

Accordingly, the width TPP of the light pulses PO, with which the charge ratio R1 or R2 linearly changes relative to the distance to be measured, may be obtained for use in measurement to improve the accuracy of the calculated distance. Herein, if the charge ratio R1 exceeds a preset threshold ThW, the charge ratio R1 is switched to the charge ratio R2 to obtain a charge ratio R. The threshold ThW is determined as an upper limit of the charge ratio R1 of the time window Tw1 in the vicinity of the timing when the time windows switch from Tw1 to Tw2, i.e., an upper limit of the charge ratio R1 corresponding to the distance that can be measured in the time window Tw1.

Therefore, in the present embodiment, the width TPP of the light pulses PO with which the charge ratio becomes linear (≥ the width TP1 of the integration drive signal TX) is calculated through the following processing.

The measurement control unit 44 arbitrarily sets a light pulse width TPP in the light pulse width setting mode, and causes the light source device 21 to emit the light pulses PO from the timing synchronized with the integration drive signal TX1, with the width incremented in steps of a predetermined unit delay time ΔTD.

In this case, the object S is fixed to a predetermined position from the range imaging device 1. By emitting light pulses PO, being delayed by the delay time TD from the rise timing of the integration drive signal TX1, the distance from the range imaging device 1 to the object S is virtually changed.

The light pulse width adjustment unit 42 extracts the acquired charge ratio R after the lapse of every delay time TD, and calculates a charge ratio gradient SL from a difference ΔR in charge ratio R between adjacent delay times TD and the unit delay time ΔTD (= ΔR/ΔTD).

After calculating charge ratio gradients SL of all the delay times TD for the width TPP of the light pulses PO, the light pulse width adjustment unit 42 calculates a standard deviation of the charge ratio gradients SL for this light pulse width TPP (i.e., variation in rate of change). Although variation in rate of change is obtained using a standard deviation in the present embodiment, any indicator for evaluating variation, such as a variance, deviation value, and mean square error, can be used as an indicator for evaluating the charge ratio gradients SL for the light pulse width TPP.

The light pulse width adjustment unit 42 performs the processing of calculating a standard deviation for the width TPP of the light pulses PO mentioned above, for all the set widths TPP of the light pulses PO, and extracts a minimum standard deviation.

Thus, the light pulse width adjustment unit 42 acquires a width of the light pulses PO corresponding to the charge ratio gradients SL with a minimum standard deviation, and determines this as a light pulse width TPP to be used.

Then, in the distance measurement charge acquisition mode, the distance calculation unit 43 calculates a distance between each pixel circuit 321 and the object S from the integrated charges Q1, Q2, Q3 and Q4 of the charge integration units CS1, CS2, CS3 and CS4 in the pixel circuit 321, based on the delay time Td obtained from the following Formula (6) or (7) using the ratio R1 or R2 calculated from Formulas (1) to (5).

Specifically, the distance calculation unit 43 calculates a delay time Td using the principle described above, through the following Formula (6) or Formula (7). $Td = To \times R 1$ (6) $Td = To \times R 2$ (7)

In these formulas, To represents a period of time during which the light pulses PO are emitted. R1 represents the ratio of integrated charges in the charge integration units CS1 and CS2 in the time window Tw1 of Fig. 4. R2 represents the ratio of integrated charges in the charge integration units CS2 and CS3 in the time window Tw2 of Fig. 4.

In Formula (6), charge generated due to reflected light is integrated in the charge integration units CS1 and CS2, but is not integrated in the charge integration units CS3 and CS4. In Formula (7), charge generated due to reflected light is integrated in the charge integration units CS2 and CS3, but is not integrated in the charge integration units CS1 and CS4.

In Formula (6) or (7), of the charges integrated in the charge integration units CS1, CS2 and CS3, the component corresponding to the external light component is assumed to be the same in amount as the charge integrated in the charge integration unit CS4.

The distance calculation unit 43 multiplies the delay time Td calculated from Formula (6) or (7) by the light velocity to calculate a round-trip distance to the object S.

Then, the distance calculation unit 43 calculates 1/2 of the round-trip distance calculated above (delay time Td × c (light velocity) /2) to calculate a distance to the object S from the range image sensor 32 (i.e., the range imaging device 1).

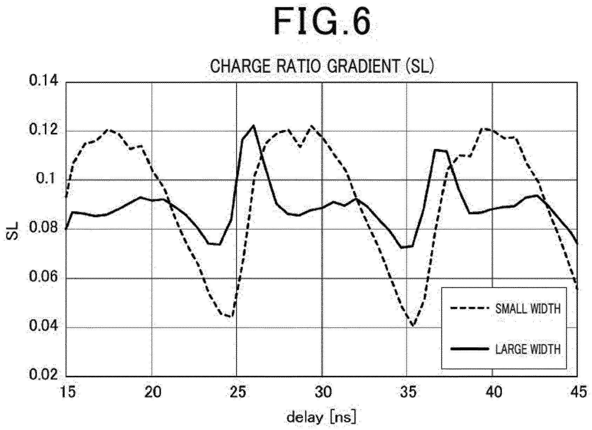

Fig. 6 is a diagram illustrating charge ratio gradients SL in the case where the light pulse width TPP (=TP1) is equal to the width TP1 of the integration drive signals TX and the case where the light pulse width TPP (>TP1) is larger than the width TP1 of the integration drive signals TX.

In Fig. 6, the horizontal axis indicates delay time TD and the vertical axis indicates charge ratio gradient SL. The dashed line indicates the charge ratio gradients SL in the case of using the light pulses PO whose width TPP (=TP1) is equal to the width TP1 of the integration drive signals TX, and the solid line indicates the charge ratio gradients SL in the case of using the light pulses PO whose width TPP (>TP1) is larger than the width TP1 of the integration drive signals TX.

As can be seen from Fig. 6, compared to the case of using the light pulses PO whose width TPP is equal to the width TP1 of the integration drive signals TX (dashed line), variation is small in the charge ratio gradients SL in the case of using the light pulses PO whose width TPP is larger than the width TP1 of the integration signals TX (solid line).

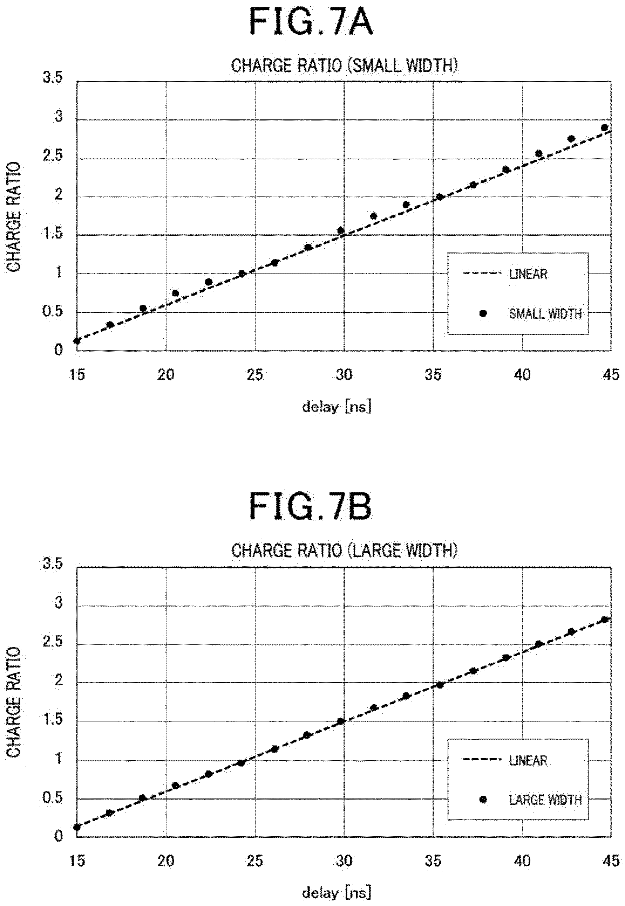

Figs. 7A and 7B are graphs each illustrating correspondence between charge ratio R and delay time TD according to the present embodiment. Fig. 7A shows correspondence between delay time TD and charge ratio R in the case of using the light pulses PO whose width is equal to the width TP1 of the integration signals TX. In Fig. 7A, the vertical axis indicates charge ratio R, and the horizontal axis indicates delay time TD.

The dashed line indicates an ideal linear line of delay time TD and charge ratio R, and the filled dots each indicate a value of the charge ratio R corresponding to the delay time TD actually measured.

As can be seen from Fig. 7A, the measured filled dots are deviated from the linear relationship between delay time TD and charge ratio R (dashed line), in the vicinity of a delay time when the time windows switch from Tw1 to Tw2 (in the vicinity of 20 ns).

Since a delay time corresponds to a measured distance, it is understood that a value deviated from the actual distance may be calculated in the case of using light pulses PO whose width TPP is equal to the width TP1 of the integration drive signals TX.

Fig. 7B shows correspondence between delay time TD and charge ratio R in the case of using the light pulses PO with a width TPP in which the standard deviation of the charge ratio gradients SL is minimum, instead of using the light pulses PO whose width TPP is equal to the width TP1 of the integration drive signals TX. In Fig. 7B, the vertical axis indicates charge ratio R, and the horizontal axis indicates delay time TD.

The dashed line indicates an ideal linear line of delay time TD and charge ratio R, and the filled dots each indicate a value of the charge ratio R corresponding to the delay time TD actually measured.

As can be seen from Fig. 7B, the measured filled dots are deviated, as in Fig. 7A, from the linear relationship between delay time TD and charge ratio R (dashed line), in the vicinity of a delay time when the time windows switch from Tw1 to Tw2 (in the vicinity of 20 ns).

However, compared to Fig. 7A in which the light pulses PO whose width TPP (=TP1) is equal to the width TP1 of the integration drive signals TX are used, errors in the actual measurements (filled dots) are reduced relative to the linear relationship between delay time TD and charge ratio R (dashed line) in the case of using the light pulses PO with a width TPP in which the standard deviation of the charge ratio gradients SL is minimum.

Thus, using the light pulses PO with a width TPP in which the standard deviation of the charge ratio gradients SL is minimum, a value closer to the actual distance can be obtained, compared to the case of using the light pulses PO whose width TPP is equal to the width TP1 of the integration drive signals TX, and thus distance accuracy can be improved.

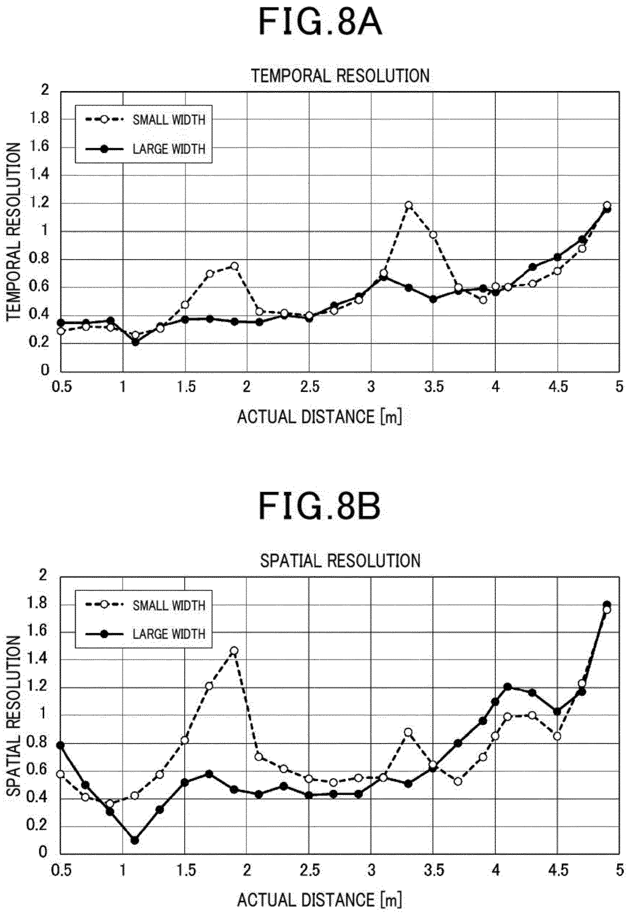

Figs. 8A and 8B are diagrams respectively illustrating temporal resolution and spatial resolution of the distance to the object S measured by the range imaging device 1.

Fig. 8A is a diagram illustrating temporal resolution of the distance to the object S measured by the range imaging device 1. In Fig. 8A, the vertical axis indicates temporal resolution, and the horizontal axis indicates actual distance between the range imaging device 1 and the object S. It should be noted that: Temporal resolution (%) = distance variation between frames / actual distance * 100. The distance variation between frames refers to a standard deviation of distance values calculated for each frame. Therefore, the unit used in the vertical axis of Fig. 8A is %.

The dashed line indicates a relationship between temporal resolution and actual distance in the case of using the light pulses PO whose width TPP is equal to the width TP1 of the integration drive signals TX.

The solid line indicates a relationship between temporal resolution and actual distance in the case of using the light pulses PO with a width TPP in which the standard deviation of the charge ratio gradients SL is minimum.

As can be seen from Fig. 8A, in the present embodiment, measuring a distance using the light pulses PO with a width TPP in which the standard deviation of the charge ratio gradients SL is minimum, temporal resolution of the distance to be measured can be improved, compared to the case of using the light pulses PO whose width TPP is equal to the width TP1 of the integration drive signals TX.

Fig. 8B is a diagram illustrating spatial resolution of the distance to the object S measured by the range imaging device 1. In Fig. 8B, the vertical axis indicates spatial resolution, and the horizontal axis indicates actual distance between the range imaging device 1 and the object S.

The dashed line indicates a relationship between spatial resolution and actual distance in the case of using the light pulses PO whose width TPP is equal to the width TP1 of the integration drive signals TX.

The solid line indicates a relationship between spatial resolution and actual distance in the case of using the light pulses PO with a width TPP in which the standard deviation of the charge ratio gradients SL is minimum.

As can be seen from Fig. 8B, in the present embodiment, measuring a distance using the light pulses PO with a width TPP in which the standard deviation of the charge ratio gradients SL is minimum, spatial resolution of the distance to be measured can be improved, compared to the case of using the light pulses PO whose width TPP is equal to the width TP1 of the integration drive signals TX.

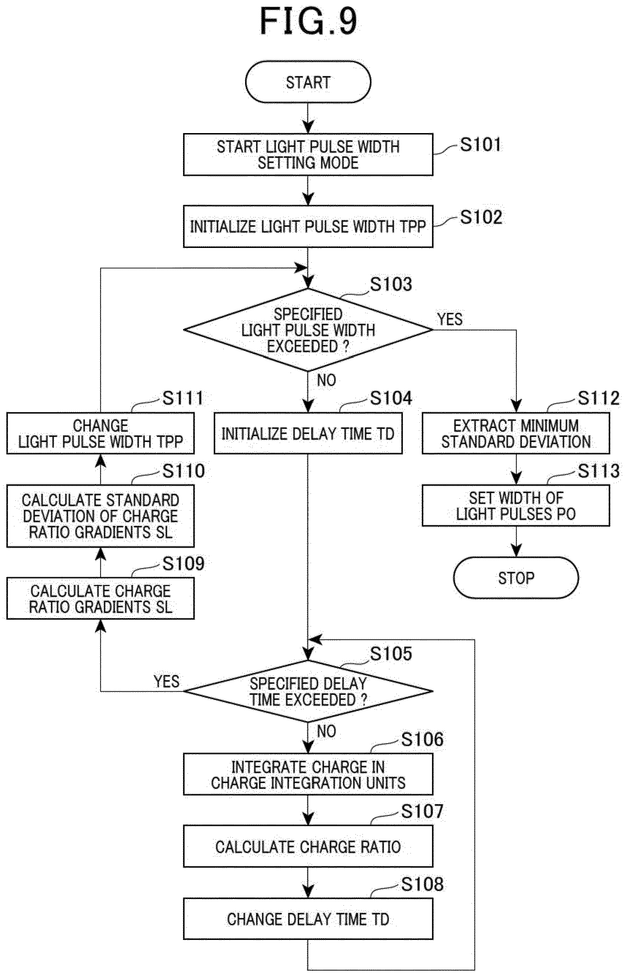

Fig. 9 is a flow chart illustrating processing of selecting a width TPP of the light pulses PO used for distance measurement in the light pulse width setting mode according to the present embodiment.

### Step S101:

The measurement control unit 44 controls the timing control unit 41 and starts working in the light pulse width setting mode.

### Step S102:

The light pulse width adjustment unit 42 determines the width TPP of the light pulses PO to be a value equal to the width TP1 of the integration drive signals TX, and sets the value at the timing control unit 41 (initialization of the width TPP of the light pulses PO).

### Step S103:

The light pulse width adjustment unit 42 determines whether the width TPP of the light pulses PO exceeds a preset upper limit (specified light pulse width).

In this case, if the width TPP of the light pulses PO does not exceed (is equal to or smaller than) the specified light pulse width that is the preset upper limit, the light pulse width adjustment unit 42 allows control to proceed to step S104.

However, if the width TPP of the light pulses PO exceeds the preset specified light pulse width, the light pulse width adjustment unit 42 allows control to proceed to step S112.

### Step S104:

The light pulse width adjustment unit 42 controls the timing control unit 41 so that the timing of emitting the light pulses PO is synchronized with the rise of the integration drive signal TX1 (initialization of the delay time TD of the light pulses PO, i.e., resetting of the delay time TD to 0).

### Step S105:

The light pulse width adjustment unit 42 determines whether the delay time TD for the timing of emitting the light pulses PO from the rise of the integration drive signal TX1 exceeds a preset upper limit (specified delay time).

In this case, if the width TPP of the light pulses PO does not exceed (is equal to or smaller than) the preset specified delay time, the light pulse width adjustment unit 42 allows control to proceed to step S106.

However, if the width TPP of the light pulses PO (≥ the width TP1 of the integration drive signal TX1) exceeds the specified delay time that is the preset upper limit, the light pulse width adjustment unit 42 allows control to proceed to step S109.

### Step S106:

In the integration period in the frame period, the light source device 21 emits the light pulses PO with a set width TPP at every integration cycle, being delayed by the delay time TD from the rise of the integration drive signal TX1.

Thus, at every integration cycle, the pixel drive circuit 322 distributes the charge generated in the photoelectric conversion element PD due to incident light to the charge integration units CS1, CS2, CS3 and CS4 for integration therein via the transfer transistors G1, G2, G3 and G4.

Herein, the integration drive signals TX1, TX2, TX3 and TX4 for the respective transfer transistors G1, G2, G3 and G4 have the same width TP1.

Distribution of charge to the charge integration units CS1, CS2, CS3 and CS4 is performed by the number of times corresponding to the preset number of integration cycles (number of distributions).

### Step S107:

The pixel drive circuit 322 supplies the integrated charges Q1, Q2, Q3 and Q4 of the respective charge integration units CS1, CS2, CS3 and CS4 of each pixel circuit 321 to the range image processing unit 4.

The light pulse width adjustment unit 42 calculates a charge ratio R for each pixel circuit 321 using Formulas (1) and (2), from the integrated charges Q1, Q2, Q3 and Q4 supplied from each pixel circuit 321.

### Step S108:

The light pulse width adjustment unit 42 adds a unit delay time ΔTD to the delay time TD, and uses the addition result as a new delay time TD (change of the delay time TD).

The light pulse width adjustment unit 42 controls the timing control unit 41 so that the timing of emitting the light pulses PO is delayed by the delay time TD from the rise of the integration drive signal TX1.

### Step S109:

The light pulse width adjustment unit 42 calculates a difference ΔR in charge ratio R between the delay time TD targeted for processing and the delay time TD immediately before, for all the measured delay times TD.

Also, the light pulse width adjustment unit 42 divides each calculated difference ΔR between delay times TD, by a unit delay time ΔTD for each pixel circuit 321 (i.e., pixel) to obtain charge ratio gradients SL between the individual delay times TD.

### Step S110:

Then, the light pulse width adjustment unit 42 calculates, for each pixel circuit 321, a standard deviation s of the charge ratio gradients SL for the pulse width TPP at this time point, from the charge ratio gradients SL between the individual delay times TD.

Furthermore, the light pulse width adjustment unit 42 calculates an average of the standard deviations s of all the pixel circuits 321, for use as a standard deviation s_av.

### Step S111:

The light pulse width adjustment unit 42 adds a unit duration ΔTPP to the width TPP of the light pulses PO, and uses the addition result as a new light pulse width TPP (change of the light pulse width TPP).

Then, the light pulse width adjustment unit 42 controls the timing control unit 41 so that the width TPP of the light pulses PO to be emitted will have a newly set light pulse width TPP obtained by adding the unit duration ΔTPP.

### Step S112:

The light pulse width adjustment unit 42 selects a light pulse width TPP in which the standard deviation s_av is minimum, from the widths TPP of the light pulses PO.

### Step S113:

The light pulse width adjustment unit 42 sets the selected light pulse width TPP as a light pulse width TPP minimizing variation in charge ratio gradients SL and maximizing accuracy when measuring the distance between the range imaging device 1 and the object S, in each of the pixel circuits 321.

In the processing at steps S109 and S110 of the flow chart described above, standard deviations s are calculated for all the pixel circuits 321 of the range image sensor 32, and a standard deviation s_av is calculated as an average of the standard deviations s.

However, instead of using the average of the standard deviations s of all the pixel circuits 321 of the range image sensor 32, an average of the standard deviations s in a predetermined region, e.g., the center part, of the pixel circuits 321 of the range image sensor 32 may be used as a standard deviation s_av.

In the case of this configuration, the light pulse width adjustment unit 42 may perform processing of calculating standard deviations s for only the predetermined pixel circuits 321 in the center region of the range image sensor 32.

Alternatively, multiple positionally separated pixel circuits 321 at predetermined positions in the range image sensor 32 may be determined in advance, and an average of the multiple standard deviations s of these multiple pixel circuits 321 may be used as a standard deviation s_av.

In the case of this configuration, the light pulse width adjustment unit 42 may perform processing of calculating standard deviations s for only the predetermined pixel circuits 321 at the predetermined positions in the range image sensor 32.

At step S107, the light pulse width adjustment unit 42 may calculate an average of the charge ratios R obtained from all the pixel circuits 321, and may use this average as a charge ratio R of the range image sensor 32, for calculation of the differences ΔR in charge ratio R in the individual delay times TD.

In the case of this configuration, at steps S109 and S110, the light pulse width adjustment unit 42 may calculate a standard deviation s of the charge ratio gradients SL calculated from the differences ΔR and the unit delay time ΔTD, for use as a standard deviation s_av.

At step S107, instead of calculating an average of the charge ratios R obtained from all the pixel circuits 321, the light pulse width adjustment unit 42 may calculate differences ΔR in charge ratio R in the individual delay times TD, using an average of the charge ratios R of the pixel circuits 321 in a predetermined region, e.g., a center region, of the range image sensor 32.

In the case of this configuration, at steps S109 and S110, the light pulse width adjustment unit 42 may calculate a standard deviation s of the charge ratio gradients SL calculated from the differences ΔR, which have been calculated from the charge ratios R of the pixel circuits 321 in the center region, and the unit delay time ΔTD, for use as a standard deviation s_av.

At step S107, instead of calculating an average of the charge ratios R obtained from all the pixel circuits 321, the light pulse width adjustment unit 42 may calculate differences ΔR in charge ratio R in the individual delay times TD, using an average of the charge ratios R of the pixel circuits 321 in a predetermined region, e.g., at predetermined separated positions, of the range image sensor 32.

In the case of this configuration, at steps S109 and S110, the light pulse width adjustment unit 42 may calculate a standard deviation s of the charge ratio gradients SL calculated from the differences ΔR, which have been calculated from the charge ratios R of the pixel circuits 321 at the predetermined separated positions, and the unit delay time ΔTD, for use as a standard deviation s_av.

In the present embodiment, a delay time Td is calculated from Formulas (1) to (7) without specifying a gate for external light integration in advance, and a distance between the range imaging device 1 and the object S is calculated using this delay time Td.

However, if the gate for integrating charge generated due to reflected light and the gate for external light integration are known in advance, the distance calculation unit 43 may calculate a delay time Td from the following Formula (8) or (9), for calculation of a distance between the range imaging device 1 and the object S.$Td = To \times \left(Q2-Q4\right) / \left(Q1+Q2-2\times Q4\right)$ (8) $Td = To + To \times \left(Q3-Q4\right) / \left(Q2+Q3-2\times Q4\right)$ (9)

In these formulas, To represents a period during which the light pulses PO are emitted. Q1 represents the integrated charge in the charge integration unit CS1. Q2 represents the integrated charge in the charge integration unit CS2. Q3 represents the integrated charge in the charge integration unit CS3. Q4 represents the integrated charge in the charge integration unit CS4.

In Formula (8), charge generated due to reflected light is integrated in the charge integration units CS1 and CS2, but is not integrated in the charge integration units CS3 and CS4 (time window Tw1). However, in Formula (9), charge generated due to reflected light is integrated in the charge integration units CS2 and CS3, but is not integrated in the charge integration units CS1 and CS4 (time window Tw2).

In Formula (8) or (9), of the charges integrated in the charge integration units CS1, CS2 and CS3, the component corresponding to the external light component is assumed to be the same in amount as the charge integrated in the charge integration unit CS4.

### <Second Embodiment>

With reference to the drawings, a second embodiment of the present invention will be described. The second embodiment has a configuration similar to the range imaging device 1 according to the first embodiment shown in Fig. 1.

A range imaging device 1 according to the second embodiment will be described focusing on the operation different from the first embodiment.

The processing for calculating a width TPP of the light pulses PO used for measurement is performed as in the first embodiment.

In the first embodiment, integrated charges Q1, Q2, Q3 and Q4 are acquired from the charge integration units CS1, CS2, CS3 and CS4 of each pixel circuit 321, and a distance between the pixel circuit 321 of the range image sensor 32 and the object S is calculated from the delay time Td obtained from Formulas (1) to (7).

In the second embodiment, a distance between the pixel circuit 321 and the object S is calculated (estimated) using a correspondence table showing a relationship between charge ratio R (calculated from the charge ratio R1 or R2 and the threshold ThW of the first embodiment) and estimated distance (corresponding to the distance between the pixel circuit 321 and the object S).

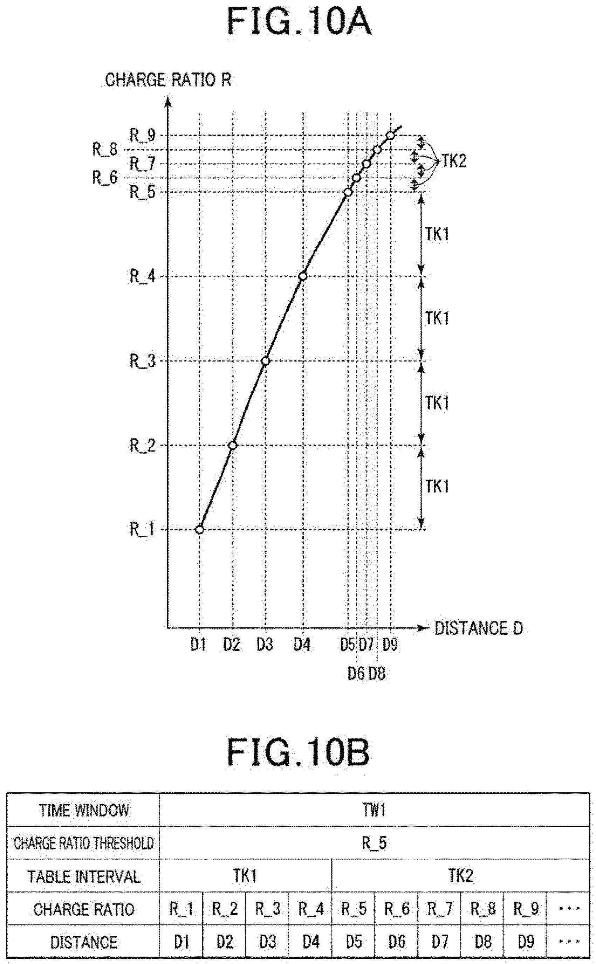

In the present embodiment, first, a distance from the range imaging device 1 to the object S is changed in steps of a predetermined unit distance according to the width TPP of the light pulses PO obtained in the first embodiment, and distance images are captured to acquire charge ratios R. In other words, a distance measurement experiment is conducted, and using the known distances, charge ratios R in these distances are calculated to acquire a variation curve as shown in Fig. 10A.

Obtaining a variation curve of the charge ratios R and distances, linear regions in the variation curve, in which charge ratios R vary linearly with distances, are extracted.

Fig. 10A explains a correspondence table indicating a relationship between charge ratio R and estimated distance according to the second embodiment.

Fig. 10A is a graph indicating correspondence between charge ratio R and estimated distance, in which the vertical axis indicates charge ratio R and the horizontal axis indicates distance (estimated distance).

For example, the graph shown in Fig. 10A indicates correspondence between the charge ratio R corresponding to the time window Tw1 and estimated distance. A similar graph may be acquired for the time window Tw2.

In Fig. 10A, the region between the charge ratios R_1 and R_2, the region between the charge ratios R_2 and R_3, ... and the region between the charge ratios R_8 and R_9 are (regarded to be) linear regions in each of which charge ratio R varies linearly with distance.

Using the light pulses PO with a width TPP (>TP1) larger than the width TP1 of the integration drive signals TX calculated in the first embodiment, variation in the charge ratio gradients SL can be suppressed, as shown in Fig. 6, compared to the case of using a width TPP (=TP1) equal to the width TP1 of the integration drive signals TX.

In other words, in the variation curve shown in Fig. 10A, regions (table intervals TK) in each of which charge ratio R varies linearly with distance become longer.

Therefore, using the light pulses PO whose width TPP (>TP1) is larger than the width TP1 of the integration drive signals TX, the number of charge ratios R represented in the variation curve can be reduced, compared to the case of using the width TPP (=TP1) equal to the width TP1 of the integration drive signals TX.

Fig. 10B is a diagram illustrating a configuration example of the correspondence table indicating a relationship between charge ratio R and estimated distance. The correspondence table is provided for each time window. The table shown in Fig. 10B corresponds to the time window Tw1.

The charge ratio R_5 indicates a threshold at which the distance interval over which the charge ratio gradients SL vary becomes shorter. When the charge ratio is lower than R_5, the interval between the charge ratios R is the table interval TK1; however, when the charge ratio is R_5 or higher (near the time window border), the interval between the charge ratios R is the table interval TK2 (<TK1) shorter than the table interval TK1.

In Fig. 10B, the charge ratios R are correlated to respective distances. For example, with the charge ratio R_1 being correlated to the distance D1, and the charge ratio R_2 being correlated to the distance D2, etc., the correspondence table shown in Fig. 10B is stored in advance in a storage unit, not shown, for each time window. The correspondence tables are stored in the storage unit for each of all the pixel circuits 321 of the range image sensor 32, or for each of multiple divisions of the range image sensor 32.

The distance calculation unit 43 calculates a charge ratio R using Formulas (1) and (2), from the integrated charges Q1, Q2, Q3 and Q4 supplied from the respective charge integration units CS1, CS2, CS3 and CS4 of each pixel circuit 321.

Then, the distance calculation unit 43 searches the correspondence table shown in Fig. 10B for a charge ratio R_n equal to the calculated charge ratio R. When a charge ratio R_n equal to the charge ratio R has been searched, a distance Dn corresponding to the charge ratio R_n is read out for use as a distance between the pixel circuit 321 and the object S.

If no charge ratio R_n equal to the calculated charge ratio R has been searched, the distance calculation unit 43 refers to the correspondence table of Fig. 10B and extracts charge ratios R_n-1 and Rn in which the charge ratio R is included.

Then, the distance calculation unit 43 reads out distances Dn-1 and Dn corresponding to the respective charge ratios R_n-1 and Rn, and performs linear interpolation in which the distances Dn-1 and Dn are correlated to the charge ratio R to calculate a distance D corresponding to the charge ratio R, for use as a distance between the pixel circuit 321 and the object S.

### <Third Embodiment>

With reference to the drawings, a third embodiment of the present invention will be described. The third embodiment has a configuration similar to the range imaging device 1 according to the first embodiment shown in Fig. 1.

A range imaging device 1 according to the third embodiment will be described focusing on the operation different from the first embodiment.

The processing for calculating a width TPP of the light pulses PO used for measurement is performed as in the first embodiment.

In the second embodiment described above, a correspondence table indicating correlation between charge ratio R and distance D has been referred to to acquire a distance, by extraction or linear interpolation, corresponding to the charge ratio R calculated from the integrated charges Q1, Q2, Q3 and Q4 of the respective charge integration units CS1, CS2, CS3 and CS4.

In the third embodiment, being correlated to the variation curve of charge ratio R and distance D shown in Fig. 10A, correspondence between known distance and measured distance D is approximated in advance using a polynomial, with the distance D as being an indeterminate.

Then, the distance calculation unit 43 substitutes a measured distance D into the polynomial to correct the error in the distance D from the actual distance.

Specifically, with a polynomial for approximating a distance error from a known distance obtained in advance, the distance calculation unit 43 substitutes a measured distance D calculated using a charge ratio into the polynomial to approximate the distance D to the actual distance and correct the distance error, thereby obtaining a distance D in which the distance error from the actual distance has been reduced.

The approximation using the polynomial is performed according to the charge ratio gradients SL in the variation curve shown in Fig. 10A.

Thus, using the light pulses PO with a width TPP (>TP1) larger than the width TP1 of the integration drive signals TX calculated in the first embodiment, variation in the charge ratio gradients SL can be suppressed, as shown in Fig. 6, compared to the case of using a width TPP (=TP1) equal to the width TP1 of the integration drive signals TX.

According to the present embodiment, using the light pulses PO with a width TPP (>TP1) larger than the width TP1 of the integration drive signals TX, variation in the charge ratio gradients SL can be suppressed, compared to the case of using a width TPP (=TP1) equal to the width TP1 of the integration drive signals TX. Accordingly, while reducing the number of terms and degree of indeterminates (charge ratios as a variables) in the polynomial for approximating the variation curve, and reducing calculation load due to use of a charge ratio R, an approximation formula that can obtain a distance D with high approximation accuracy can be obtained.

In the present embodiment, using the light pulses PO with a width TPP (>TP1) larger than the width TP1 of the integration drive signals TX, it is considered that there may be a case in which charge generated due to the reflected light RL is integrated across three of the charge integration units CS1, CS2, CS3 and CS4, e.g., the charge integration units CS1, CS2 and CS3.

Thus, if charge is integrated across three charge integration units, the distance between the range imaging device 1 and the object S may be configured to be calculated based on three integrated charges Q with overlapping reflected light RL.

### [Industrial Applicability]

There can be provided a range imaging device and a range imaging method, which are able to prevent charge from being integrated in only one of two charge integration units due to the light pulse width becoming smaller due to the light pulse waveform becoming less sharp, and are able to reduce the error between the distance obtained based on the charge ratio of the charge integration units and the actual distance between the pixel and the object.

### [Reference Signs List]

1 ... Range imaging device
2 ... Light source unit
3 ... Light-receiving unit
31 ... Lens
32 ... Range image sensor (range imaging device)
321 ... Pixel circuit
322 ... Pixel drive circuit
4 ... Range image processing unit
41 ... Timing control unit
42 ... Light pulse width adjustment unit
43 ... Distance calculation unit
44 ... Measurement control unit
CS1, CS2, CS3, CS4 ... Charge integration unit
FD1, FD2, FD3, FD4 ... Floating diffusion
G1, G2, G3, G4 ... Transfer transistor
GD ... Charge discharge transistor
ML ... Microlens
PD ... Photoelectric conversion element
PO ... Light pulses
RT1, RT2, RT3, RT4 ... Reset transistor
S ... Object
SF1, SF2, SF3, SF4 ... Source follower transistor
SL1, SL2, SL3, SL4 ... Selection transistor

## Claims

1. A range imaging device (1) comprising
a light source unit (2) configured to emit light pulses (PO) to a measurement space;
a light-receiving unit (3) that includes at least one pixel circuit (321) and a pixel drive circuit (322), the at least one pixel circuit (321) including a photoelectric conversion element (PD) configured to generate charge according to light incident from the measurement space, and a plurality of charge integration units (CS1, ..., CS4) in which the charge is integrated in a frame cycle, the pixel drive circuit (322) being configured to supply integration drive signals (TX1, ..., TX4) to respective transfer transistors (G1, ..., G4) to distribute the charge generated in the photoelectric conversion element (PD) to the charge integration units (CS1, ..., CS4) for integration therein via said respective transfer transistors (G1, ...G4) at a predetermined integration timing synchronized with emission of the light pulses (PO); and
a distance calculation unit (43) configured to calculate a distance between an object (S) and the light-receiving unit (3), based on a charge ratio of charge generated in the photoelectric conversion element (PD) due to reflected light (RL) from the measurement space and distributed to the charge integration units (CS1, ..., CS4) for integration therein by the respective transfer transistors (G1, ..., G4) and on a delay time (Td) from when the light pulses (PO) are emitted until when the reflected light (RL) is received, based on the charge integrated in the plurality of charge integration units (CS1, ..., CS4), wherein
the light pulses (PO) have a width (TPP) set to be larger than a period between a rise of a specific transfer transistor and a rise of the subsequently rising transfer transistor among the transfer transistors (G1, ..., G4);
**characterized in that** the width (TPP) of the light pulses (PO) is set according to variation in rate of change of the charge ratio in response to changes in delay time from when the light pulses (PO) are emitted until when the reflected light is incident.

2. The range imaging device according to claim 1, wherein the range imaging device is configured, while sequentially changing the width (TPP) of the light pulses (PO), to obtain the variation in rate of change of the charge ratio in the changes in delay time for each width of the light pulses (PO) to select the width in which the variation is minimized, and the selected width is set as the width of the light pulses (PO).

3. The range imaging device according to any one of claims 1 to 2, wherein
the distance calculation unit (43) is configured to calculate the distance, based on table information that indicates a relationship between distance corresponding to a distance between the object (S) and a pixel, and to calculate charge ratio from charge integrated in the charge integration units (CS1, ..., CS4).

4. The range imaging device according to any one of claims 1 to 2, wherein
the distance calculation unit (43) is configured to obtain a polynomial in advance that approximates a distance error between the distance calculated using the charge ratio and a known distance, and to calculate the distance with the distance error corrected using the polynomial.

5. A range imaging method for controlling a range imaging device (1) including a light source unit (2), at least one pixel circuit (321), a pixel drive circuit (322), and a distance calculation unit (43), the at least one pixel circuit (321) being configured by a photoelectric conversion element (PD), a plurality of charge integration units (CS1, ..., CS4), and transfer transistors (G1, ..., G4), comprising steps of:
integrating charge generated in the photoelectric conversion element (PD) in the charge integration units (CS1, ..., CS4) in a frame cycle via respective transfer transistors (G1, ..., G4) that transfer the charge to the charge integration units (CS1, ..., CS4) from the photoelectric conversion element (PD) by supplying integration drive signals (TX1, ..., TX4) to respective transfer transistors (G1, ..., G4) , the charge being generated in the photoelectric conversion element (PD) due to light incident from a measurement space at a predetermined integration cycle synchronized with emission of light pulses (PO) from the light source unit (2), as performed by the pixel drive circuit (322); and
calculating a distance between an object (S) and the range imaging device (1), based on a charge ratio of charge generated due to reflected light from the measurement space and distributed by the transfer transistors (G1, ..., G4) from the photoelectric conversion element (PD) to the charge integration units (CS1, ..., CS4) for integration therein, as performed by the distance calculation unit (43), and based on a delay time (Td) from when the light pulses (PO) are emitted until when the reflected light (RL) is received, based on the charge integrated in the plurality of charge integration units (CS1, ..., CS4), wherein
the light pulses (PO) have a width set to be larger than a period between a rise of a specific transfer transistor and a rise of the subsequently rising transfer transistor among the transfer transistors (G1, ..., G4);
**characterized in that** the width (TPP) of the light pulses (PO) is set according to variation in rate of change of the charge ratio in response to changes in delay time from when the light pulses (PO) are emitted until when the reflected light is incident.

## Patentansprüche

1. Entfernungsbildaufnahmevorrichtung (1), umfassend:
eine Lichtquelleneinheit (2), welche dazu eingerichtet ist, Lichtpulse (PO) in einen Messraum zu emittieren;
eine Lichtempfangseinheit (3), welche wenigstens eine Pixelschaltung (321) und eine Pixelsteuerschaltung (322) umfasst, wobei die wenigstens eine Pixelschaltung (321) ein photoelektrisches Umwandlungselement (PD) umfasst, welches dazu eingerichtet ist, eine Ladung gemäß Licht zu erzeugen, welches von dem Messraum einfallend ist, und eine Mehrzahl von Ladungsintegrationseinheiten (CS1, ..., CS4) umfasst, in welchen die Ladung in einen Einzelbildzyklus integriert ist, wobei die Pixelsteuerschaltung (322) dazu eingerichtet ist, jeweiligen Transfertransistoren (G1, ..., G4) Integrationssteuersignale (TX1, ..., TX4) zuzuführen, um die Ladung, welche in dem photoelektrischen Umwandlungselement (PD) erzeugt worden ist, zur Integration darin mittels der jeweiligen Transfertransistoren (G1, ..., G4) an einem vorbestimmten Integrationszeitpunkt, welcher mit der Emission der Lichtpulse (PO) synchronisiert ist, an die Ladungsintegrationseinheiten (CS1, ..., CS4) zu verteilen; und
eine Distanzberechnungseinheit (43), welche dazu eingerichtet ist, eine Distanz zwischen einem Objekt (S) und der Lichtempfangseinheit (3) auf Grundlage eines Ladungsverhältnisses einer Ladung, welche durch reflektiertes Licht (RL) von dem Messraum in dem photoelektrischen Umwandlungselement (PD) erzeugt worden ist und welche zur Integration darin durch die jeweiligen Transfertransistoren (G1, ..., G4) an die Ladungsintegrationseinheiten (CS1, ..., CS4) verteilt worden ist, und auf Grundlage einer Verzögerungszeit (Td) zu berechnen, beginnend wenn die Lichtpulse (PO) emittiert werden, bis das reflektierte Licht (RL) empfangen wird, auf Grundlage der Ladung, welche in der Mehrzahl von Ladungsintegrationseinheiten (CS1, ..., CS4) integriert ist, wobei
die Lichtpulse (PO) eine Breite (TPP) aufweisen, welche dazu festgelegt ist, größer als eine Periode zwischen einer Zunahme eines spezifischen Transfertransistors und einer Zunahme des nachfolgend zunehmenden Transfertransistors unter den Transfertransistoren (G1, ..., G4) zu sein;
**dadurch gekennzeichnet, dass** die Breite (TPP) der Lichtpulse (PO) gemäß einer Variation einer Änderungsrate des Ladungsverhältnisses als Reaktion auf Änderungen der Verzögerungszeit, beginnend wenn die Lichtpulse (PO) emittiert werden, bis das reflektierte Licht einfallen ist, festgelegt wird.

2. Entfernungsbildaufnahmevorrichtung nach Anspruch 1, wobei die Entfernungsbildaufnahmevorrichtung dazu eingerichtet ist, während eines sequenziellen Änderns der Breite (TPP) der Lichtpulse (PO), die Variation der Änderungsrate des Ladungsverhältnisses bei den Änderungen der Verzögerungszeit für jede Breite der Lichtpulse (PO) zu erhalten, um die Breite auszuwählen, bei welcher die Variation minimal ist, und wobei die ausgewählte Breite als die Breite der Lichtpulse (PO) festgelegt wird.

3. Entfernungsbildaufnahmevorrichtung nach einem der Ansprüche 1 bis 2, wobei
die Distanzberechnungseinheit (43) dazu eingerichtet ist, die Distanz auf Grundlage von Tabelleninformationen zu berechnen, welche eine Beziehung zwischen einer Distanz indiziert, welcher einer Distanz zwischen dem Objekt (S) und einem Pixel entspricht, und ein Ladungsverhältnis aus einer Ladung zu berechnen, welche in den Ladungsintegrationseinheiten (CS1, ..., CS4) integriert ist.

4. Entfernungsbildaufnahmevorrichtung nach einem der Ansprüche 1 bis 2, wobei
die Distanzberechnungseinheit (43) dazu eingerichtet ist, im Voraus ein Polynom zu erhalten, welches einem Distanzfehler zwischen der Distanz, welche unter Verwendung des Ladungsverhältnisses berechnet worden ist, und einer bekannten Distanz entspricht, und die Distanz mit dem Distanzfehler zu berechnen, welcher unter Verwendung des Polynoms korrigiert worden ist.

5. Entfernungsbildaufnahmeverfahren zum Steuern einer Entfernungsbildaufnahmevorrichtung (1), welche eine Lichtquelleneinheit (2), wenigstens eine Pixelschaltung (321), eine Pixelsteuerschaltung (322) und eine Distanzberechnungseinheit (43) umfasst, wobei die wenigstens eine Pixelschaltung (321) durch ein photoelektrisches Umwandlungselement (PD), eine Mehrzahl von Ladungsintegrationseinheiten (CS1, ..., CS4) und Transfertransistoren (G1, ..., G4) eingerichtet ist, umfassend die Schritte aus:
Integrieren einer Ladung, welche in dem photoelektrischen Umwandlungselement (PD) erzeugt wird, in die Ladungsintegrationseinheiten (CS1, ..., CS4) mittels jeweiliger Transfertransistoren (G1, ..., G4), welche die Ladung zu den Ladungsintegrationseinheiten (CS1, ..., CS4) übertragen, in einem Einzelbildzyklus von dem photoelektrischen Umwandlungselement (PD) durch Zuführen von Integrationssteuersignalen (TX1, ..., TX4) zu jeweiligen Transfertransistoren (G1, ..., G4), wobei die Ladung in dem photoelektrischen Umwandlungselement (PD) durch Licht, welches zu einem vorbestimmten Integrationszyklus, welcher mit einer Emission von Lichtpulsen (PO) synchronisiert ist, von einem Messraum einfällt, von der Lichtquelleneinheit (2) erzeugt wird, wie durch die Pixelsteuerschaltung (322) durchgeführt; und
Berechnen einer Distanz zwischen einem Objekt (S) und der Entfernungsbildaufnahmevorrichtung (1) auf Grundlage eines Ladungsverhältnisses einer Ladung, welche durch reflektiertes Licht von dem Messraum erzeugt worden ist und durch die Transfertransistoren (G1, ..., G4) von dem photoelektrischen Umwandlungselement (PD) an die Ladungsintegrationseinheiten (CS1, ..., CS4) zur Integration darin verteilt worden ist, wie von der Distanzberechnungseinheit (43) durchgeführt, und auf Grundlage einer Verzögerungszeit (Td), beginnend wenn die Lichtpulse (PO) emittiert werden, bis das reflektierte Licht (RL) empfangen wird, auf Grundlage der Ladung, welche in der Mehrzahl von Ladungsintegrationseinheiten (CS1, ..., CS4) integriert ist, wobei
die Lichtpulse (PO) eine Breite aufweisen, welche dazu festgelegt ist, größer als eine Periode zwischen einer Zunahme eines spezifischen Transfertransistors und einer Zunahme des nachfolgend zunehmenden Transfertransistors unter den Transfertransistoren (G1, ..., G4) zu sein;
**dadurch gekennzeichnet, dass** die Breite (TPP) der Lichtpulse (PO) gemäß einer Variation einer Änderungsrate des Ladungsverhältnisses als Reaktion auf Änderungen der Verzögerungszeit, beginnend wenn die Lichtpulse (PO) emittiert werden, bis das reflektierte Licht einfallen ist, festgelegt wird.

## Revendications

1. Dispositif de formation d'image télémétrique (1) comprenant une unité source de lumière (2) configurée pour émettre des impulsions lumineuses (PO) vers un espace de mesure ;
une unité de réception de lumière (3) qui inclut au moins un circuit de pixels (321) et un circuit de commande de pixels (322), l'au moins un circuit de pixels (321) incluant un élément de conversion photoélectrique (PD) configuré pour générer une charge selon une lumière incident depuis l'espace de mesure, et une pluralité d'unités d'intégration de charge (CS1, ..., CS4) dans lesquelles la charge est intégrée dans un cycle de trame, le circuit de commande de pixels (322) étant configuré pour fournir des signaux de commande d'intégration (TX1, ..., TX4) à des transistors de transfert respectifs (G1, ..., G4) pour distribuer la charge générée dans l'élément de conversion photoélectrique (PD) aux unités d'intégration de charge (CS1, ..., CS4) pour intégration dans celles-ci via lesdits transistors de transfert respectifs (G1, ..., G4) à un moment d'intégration prédéterminé synchronisé avec l'émission des impulsions lumineuses (PO) ; et
une unité de calcul de distance (43) configurée pour calculer une distance entre un objet (S) et l'unité de réception de lumière (3), sur la base d'un rapport de charge générée dans l'élément de conversion photoélectrique (PD) en raison de la lumière réfléchie (RL) par l'espace de mesure et distribuée aux unités d'intégration de charge (CS1, ..., CS4) pour intégration dans celles-ci par les transistors de transfert respectifs (G1, ..., G4) et d'un temps de retard (Td) à partir du moment où les impulsions lumineuses (PO) sont émises jusqu'à la réception de la lumière réfléchie (RL), sur la base de la charge intégrée dans la pluralité d'unités d'intégration de charge (CS1, ..., CS4), dans lequel
les impulsions lumineuses (PO) présentent une largeur (TPP) définie pour être supérieure à une période entre une montée d'un transistor de transfert spécifique et une montée du transistor de transfert subséquemment montant parmi les transistors de transfert (G1, ..., G4) ;
**caractérisé en ce que** la largeur (TPP) des impulsions lumineuses (PO) est définie en fonction de la variation de la vitesse de modification du rapport de charge en réponse à des modifications de temps de retard à partir du moment où les impulsions lumineuses (PO) sont émises jusqu'au moment où la lumière réfléchie est incidente.

2. Dispositif de formation d'image télémétrique selon la revendication 1, dans lequel le dispositif de formation d'image télémétrique est configuré, tout en modifiant séquentiellement la largeur (TPP) des impulsions lumineuses (PO), pour obtenir la variation de la vitesse de modification du rapport de charge des modifications du temps de retard pour chaque largeur des impulsions lumineuses (PO) afin de sélectionner la largeur dans laquelle la variation est réduite au minimum, et la largeur sélectionnée est définie en tant que largeur des impulsions lumineuses (PO).

3. Dispositif de formation d'image télémétrique selon l'une quelconque des revendications 1 à 2, dans lequel
l'unité de calcul de distance (43) est configurée pour calculer la distance, sur la base d'informations de table qui indiquent une relation entre la distance correspondant à une distance entre l'objet (S) et un pixel, et pour calculer le rapport de charge à partir de la charge intégrée dans les unités d'intégration de charge (CS1, ..., CS4).

4. Dispositif de formation d'image télémétrique selon l'une quelconque des revendications 1 à 2, dans lequel
l'unité de calcul de distance (43) est configurée pour obtenir à l'avance un polynôme qui approxime une erreur de distance entre la distance calculée à l'aide du rapport de charge et une distance connue, et pour calculer la distance avec l'erreur de distance corrigée à l'aide du polynôme.

5. Procédé de formation d'image télémétrique pour commander un dispositif de formation d'image télémétrique (1) incluant une unité source de lumière (2), au moins un circuit de pixels (321), un circuit de commande de pixels (322) et une unité de calcul de distance (43), l'au moins un circuit de pixels (321) étant configuré par un élément de conversion photoélectrique (PD), une pluralité d'unités d'intégration de charge (CS1, ..., CS4), et des transistors de transfert (G1, ..., G4), comprenant des étapes de :
intégration d'une charge générée dans l'élément de conversion photoélectrique (PD) dans les unités d'intégration de charge (CS1, ..., CS4) dans un cycle de trame via des transistors de transfert respectifs (G1, ..., G4) qui transfèrent la charge aux unités d'intégration de charge (CS1, ..., CS4) à partir de l'élément de conversion photoélectrique (PD) en fournissant des signaux de commande d'intégration (TX1, ..., TX4) à des transistors de transfert respectifs (G1, ..., G4), la charge étant générée dans l'élément de conversion photoélectrique (PD) en raison d'une lumière incidente depuis un espace de mesure selon un cycle d'intégration prédéterminé synchronisé avec l'émission d'impulsions lumineuses (PO) de l'unité source de lumière (2), tel que réalisé par le circuit de commande de pixels (322) ; et
calcul d'une distance entre un objet (S) et le dispositif de formation d'image télémétrique (1), sur la base d'un rapport de charge générée en raison de la lumière réfléchie par l'espace de mesure et distribuée par les transistors de transfert (G1, ..., G4) de l'élément de conversion photoélectrique (PD) aux unités d'intégration de charge (CS1, ..., CS4) pour intégration dans celles-ci, tel que réalisé par l'unité de calcul de distance (43), et sur la base d'un temps de retard (Td) à partir du moment où les impulsions lumineuses (PO) sont émises jusqu'à la réception de la lumière réfléchie (RL), sur la base de la charge intégrée dans la pluralité d'unités d'intégration de charge (CS1, ..., CS4), dans lequel
les impulsions lumineuses (PO) présentent une largeur définie pour être supérieure à une période entre une montée d'un transistor de transfert spécifique et une montée du transistor de transfert montant par la suite parmi les transistors de transfert (G1, ..., G4) ;
**caractérisé en ce que** la largeur (TPP) des impulsions lumineuses (PO) est définie en fonction de la variation de la vitesse de modification du rapport de charge en réponse à des modifications de temps de retard à partir du moment où les impulsions lumineuses (PO) sont émises jusqu'au moment où la lumière réfléchie est incidente.
